# EUROPÄISCHE PATENTANMELDUNG

(11) **EP 2 110 675 A2**
(43) Veröffentlichungstag der Anmeldung: **21.10.2009**
(21) Anmeldenummer: 09005427.1
(22) Anmeldetag: 16.04.2009
(51) Int. Cl.: G01R 19/165

(54) **Vorrichtung zur Überwachung elektrischer Versorgungsleitungen**

(30) Priorität: 16.04.2008 DE 102008019274
(71) Anmelder: Grönke, Jens, 50226 Frechen (DE)
(72) Erfinder: Grönke, Jens, 50226 Frechen (DE)
(74) Vertreter: Grünecker, Kinkeldey, Stockmair & Schwanhäusser Anwaltssozietät

(57) **Zusammenfassung**

Zur Überwachung elektrischer Versorgungsleitungen (11) auf Überspannungen ist ein Überwachungsmodul (10) vorgesehen, in welchem Überspannungen mit Datum und Uhrzeit des Auftretens gespeichert werden. Damit kann das Auftreten von Überspannungen nachgewiesen werden. Die Erfindung ist hilfreich bei Versicherungen gegen Überspannungsschäden und bei Feuerversicherungen, um das Auftreten eines Ereignisses, das einen Schaden auslösen konnte, nachzuweisen.

## Beschreibung

Die Erfindung betrifft eine Vorrichtung zur Überwachung elektrischer Versorgungsleitungen auf abnorme Zustände.

Beim Betrieb elektronischer und elektrischer Geräte können durch Überspannungen Schäden auftreten, die als "Überspannungsschaden" bezeichnet werden. Überspannungen können vom Versorgungsnetz her in das elektrische Gerät hineingetragen werden. Es gibt auch elektrische Verbraucher, die ihrerseits Überspannungen erzeugen, sei es bei normalem Betrieb, sei es in Folge von Betriebsstörungen. Die Versicherungswirtschaft bietet Sachversicherungen gegen Überspannungsschäden an. Die Existenz solcher Versicherungen eröffnet die Möglichkeiten des Betruges, indem ein Schaden, der durch unsachgemäße Handhabung oder auf andere Weise entstanden ist, als Überspannungsschaden deklariert wird. Andere Schäden, die durch Stromspannungen hervorgerufen werden können, sind Brandschäden, die oftmals durch Kurzschlüsse oder auch Überspannungen erzeugt werden.

Der Erfindung liegt die Aufgabe zugrunde, eine Vorrichtung zur Überwachung elektrischer Versorgungsleitungen zu schaffen, die die Möglichkeit bietet, das Auftreten von Überspannungen zusammen mit dem jeweiligen Zeitpunkt nachzuweisen, um die Ursache eines Schadens belegen zu können.

Die erfindungsgemäße Vorrichtung zeichnet sich durch die Merkmale des Patentanspruchs 1 aus. Die Vorrichtung weist ein Überwachungsmodul auf, das einen Spannungssensor zum Detektieren von Überspannungen und einen Speicher enthält, der eine detektierte Überspannung mit Uhrzeit des Auftretens und mindestens einem Amplitudenwert speichert.

Die erfindungsgemäße Vorrichtung zeichnet abnorme Spannungszustände an den Versorgungsleitungen auf. Hierzu können Überspannungen gehören oder auch Unterspannungen, die beispielsweise durch einen Kurzschluss entstehen. Die Vorrichtung kann ein kontinuierliches Journal des Spannungsverlaufs speichern oder alternativ die Speicherung nur im Falle des Auftretens von Abnormalitäten vornehmen, wobei die Speicherung mit dem Auftreten der Abnormalität beginnt und eine vorbestimmte Zeit nach Beendigung der Abnormalität endet. Im zweiten Fall wird weniger Speicherplatz beansprucht. Im Falle einer kontinuierlichen Aufzeichnung des Spannungsverlaufs kann eine Datenkompression erfolgen, um den benötigten Speicherplatz zu verringern.

Im Falle einer Überspannung kann auch deren Herkunft - Lieferseite oder Abnehmerseite - ermittelt und gespeichert werden. In diesem Fall ist eine Aussage darüber möglich, ob von der Abnehmerseite her eine Überspannung in das Überwachungsmodul hineingetragen wurde.

Gemäß einer bevorzugten Weiterbildung der Erfindung ist ein Ablesegerät vorgesehen, das mit einer Schnittstelle des Überwachungsmoduls verbindbar ist, zum Übertragen des Inhalts des Speichers an das Ablesegerät. Das Ablesegerät steht nur berechtigten Personen zur Verfügung. Die Kommunikation des Überwachungsmoduls mit dem Ablesegerät kann drahtlos erfolgen, insbesondere über Funk (z.B. Bluetooth). Das Ablesegerät kann mit einem Passwort gesichert werden, so dass nur berechtiget Personen das Auslesen des Speichers des Überwachungsmoduls vornehmen können.

Im Rahmen der Erfindung können zusätzlich noch andere mögliche Störungsquellen überwacht werden. Hierzu ist gemäß einer bevorzugten Ausgestaltung der Erfindung mindestens ein Hilfsmodul vorgesehen, das mit dem Überwachungsmodul kommuniziert und ein elektrisches Gerät oder einen Störungsmelder überwacht, wobei das Überwachungsmodul die Speicherung der Signale des Hilfsmoduls vornimmt. Auf diese Weise entsteht ein Netzwerk von Überwachungs- und Hilfsmodulen, wobei die Speicherung sämtlicher Störungen im Überwachungsmodul erfolgt. Das Überwachungsmodul bildet die Basiseinheit, die für die Spannungsüberwachung vorgesehen ist. Mit den Hilfsmodulen kann das Überwachungssystem auf andere Überwachungsobjekte ausgedehnt werden. Als Störungsmelder kann ein Windmesser benutzt werden oder ein Rauchmelder.

Das Überwachungsmodul kann zusätzlich mit einer Funktion ausgestattet sein, die es ermöglicht, auch den Stromverbrauch innerhalb der Aufzeichnungszeit zu speichern.

Die erfindungsgemäße Vorrichtung eignet sich als Nachweissystem für die Versicherungswirtschaft, insbesondere für Versicherungen gegen Überspannungsschäden, als auch bei Feuerversicherungen. Ferner ist die Vorrichtung geeignet, die Schadensanalyse und die Aufklärung von Sachschäden zu erleichtern.

Im Folgenden wird unter Bezugnahme auf die Zeichnungen ein Ausführungsbeispiel der Erfindung näher erläutert.

### Es zeigen:

- Fig. 1: ein schematisches Blockschaltbild der Überwachungs-vorrichtung,
- Fig. 2: die Vorrichtung nach Figur 1 in detaillierterer Form,
- Figuren 3, 4, 5: verschiedene Hilfsmodule, die in Kombination mit dem Überwachungsmodul eingesetzt werden können und
- Fig. 6: einen Störungsmelder mit einem auf dem Dach eines Hauses angeordneten Windsensor.

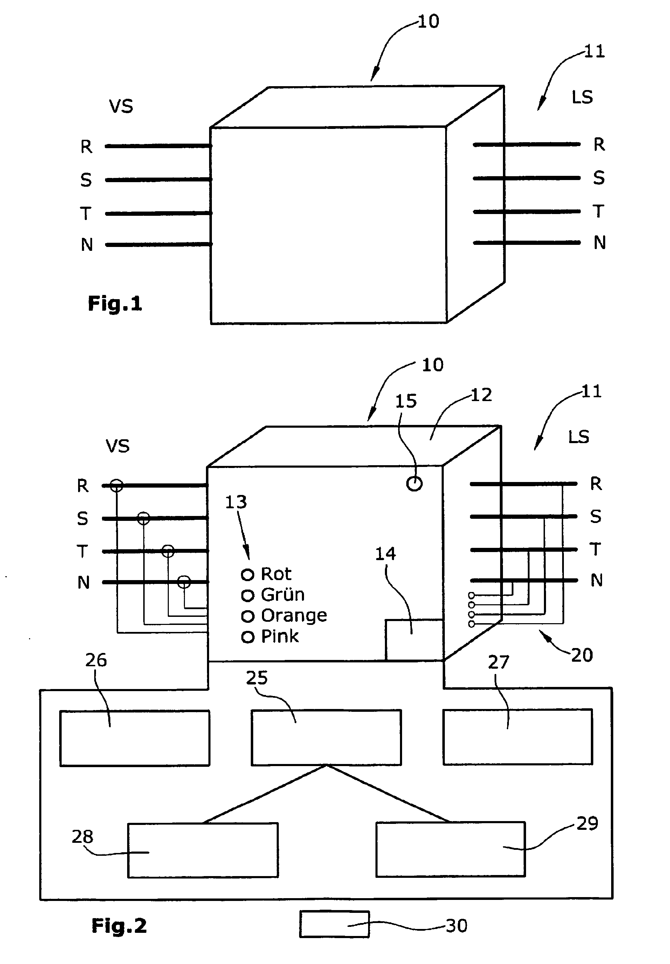

Figur 1 zeigt ein Überwachungsmodul 10, das in die Versorgungsleitungen 11 eines Stromversorgungssystems eingebaut ist. Die Versorgungsleitungen 11 führen von der Lieferseite LS zur Verbraucherseite VS. Die Versorgungsleitungen 11 umfassen hier ein 3-Phasen-Drehstromnetzwerk mit den Phasen RST und dem Nullleiter N. Zwischen jeder Phase und dem Nullleiter besteht eine Wechselspannung von 230 V.

Das Überwachungsmodul 10 überwacht die Spannungen aller drei Phasen in Bezug auf den Nullleiter. Wenn eine dieser Spannungen um mindestens einen vorbestimmten Wert von dem regulären Wert abweicht, erfolgt eine Aufzeichnung, wobei sowohl die Höhe der Spannung (Amplitude) als auch die Uhrzeit registriert wird. Das Überwachungsmodul scannt sowohl die Versorgungsleitungen 11 auf der Lieferseite LS als auch die abgehenden Versorgungsleitungen auf der Verbraucherseite VS. Das Gerät zeichnet die Störzeiten und Daten sowie die Störungsursache in digitaler Form auf, so dass registriert wird, ob und wann eine Störung aufgetreten ist.

Aufgezeichnet werden Spannung, Strom, Frequenz und Stundenzahl sowie Datum und Uhrzeit. Ferner wird aufgezeichnet, ob eine erhöhte Spannung von der Lieferseite LS oder der Verbraucherseite VS her gekommen ist. Das Überwachungsmodul 10 kann im Stromkasten bzw. Sicherungskasten einer Wohn- oder Büroeinheit installiert werden. Die Abmessungen sind so vorgesehen, dass das Überwachungsmodul in das Raster des Stromverteilerkastens passt und dort beispielsweise vier Platzeinheiten einnimmt.

Figur 2 zeigt das Gerät von Figur 1 in detaillierterer Form. Das Überwachungsmodul 10 befindet sich in einem Gehäuse 12, das an seiner Frontseite Anzeigeelemente und Bedienelemente aufweist. Die Anzeigeelemente 13 sind LEDs, die hier beispielsweise in den Farben grün, rot, orange und pink vorliegen. Die grüne LED zeigt im Leuchtzustand die Betriebsbereitschaft an und im Aus-Zustand die fehlende Betriebsbereitschaft. Die rote LED blinkt bei Störungen. Im störungsfreien Zustand ist sie aus. Die orange LED zeigt an, dass der Speicher voll ist und die rosa (pink) LED zeigt an, dass der im Überwachungsmodul enthaltene Akkumulator 14 defekt ist. Außerdem ist eine RESET-Taste 15 vorgesehen zum Rücksetzen der Software in den Hochfahrzustand. Ferner weist das Überwachungsmodul einen akustischen Signalgeber auf, der nach Auftreten einer Überspannung einen Störungssignalton intermittierend erzeugt, bis eine Entstörung durch Betätigung der RESET-Taste erfolgt ist.

Figur 2 zeigt ferner, dass die Spannungen der Phasenleitungen RST auf der Lieferseite über Leitungen 20 abgegriffen werden. Auf der Verbraucherseite sind Stromsensoren 21 an jeder der Phasenleitungen vorgesehen und die Stromsignale werden ebenfalls im Überwachungsmodul verarbeitet.

Das Überwachungsmodul enthält einen Mikrocomputer 25, einen Speicher 26, der als herausnehmbares Speicherchip ausgebildet sein kann und eine Funkuhr 27, die durch Zeitsignale, welche über Funk ausgebreitet werden, gesteuert ist. Ferner sind Schnittstellen 28 und 29 zur Kommunikation mit externen Geräten vorgesehen. Die Schnittstelle 28 ist ein Funksender/Empfänger und die Schnittstelle 29 ist eine Bluetooth-Schnittstelle. Die Schnittstellen können mit einem externen Ablesegerät 30 kommunizieren, um den Inhalt des Speichers 26 an das Ablesegerät 30 auszulesen.

Die Betriebsspannung des Überwachungsmoduls 10 wird aus der Spannung der Versorgungsleitungen 11 durch ein (nicht dargestelltes) Netzteil gewonnen. Das Netzteil lädt auch den Akkumulator 14 auf. Dieser übernimmt die Stromversorgung nur bei einem Stromausfall.

Der Speicher 26 hat beispielsweise eine Kapazität von 3 GB, womit es möglich ist, bis zu 120 Stunden den Stromverlauf aufzuzeichnen. Der Speicher kann auch als Ringspeicher ausgebildet sein, dessen Inhalt zyklisch durch Neuschreiben ersetzt wird. In einem solchen Fall bleibt stets der letzte Spannungsverlauf über einige Tage gespeichert.

Die Speicherung der Daten bzw. ihre Ausgabe aus dem Speicher an das Ablesegerät 30, kann in verschlüsselter Form erfolgen. Das Gehäuse 12 des Überwachungsmoduls 10 ist durch Verplombung manipulierungssicher.

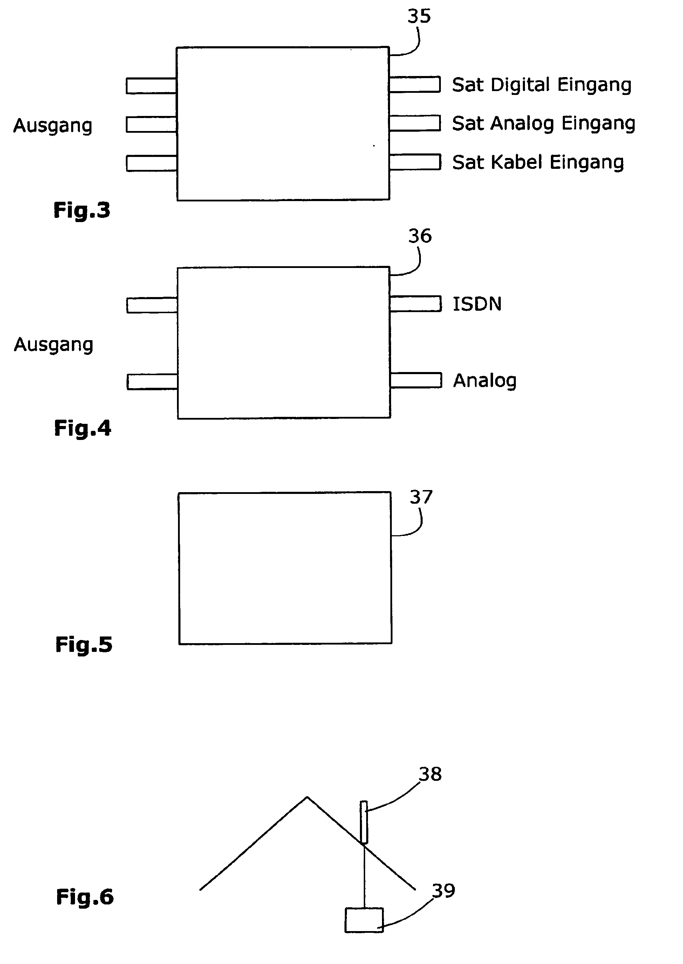

In den Figuren 3, 4 und 5 sind einige Hilfsmodule 35, 36, 37 dargestellt, die dazu dienen, andere Geräte oder Störungsmelder zu überwachen und entsprechende Signale an das Überwachungsmodul 10 zu senden. Die Kommunikation erfolgt über Funk.

Das Hilfsmodul 35 überwacht ein TV-Gerät, und zwar sowohl die Stromversorgungsleitungen als auch diverse Antennenanschlüsse. Das Überwachungsgerät 36 überwacht einen Computer. Das Überwachungsgerät 37 ist an einen Rauchmelder angeschlossen. Die Meldesignale jedes Hilfsmoduls werden von dem Überwachungsmodul 10 aufgezeichnet und im Speicher abgespeichert.

Figur 6 zeigt einen Windmesser 38, der auf dem Dach eines Hauses installiert ist und mit einem Hilfsmodul 39 verbunden ist, welches über Funk mit dem Überwachungsmodul 10 kommuniziert. In entsprechender Weise könnte auch ein Hagelsensor angeschlossen sein.

## Patentansprüche

1. Vorrichtung zur Überwachung elektrischer Versorgungsleitungen (11) auf abnorme Zustände, mit einem Überwachungsmodul (10), das einen Spannungssensor zum Detektieren von Überspannungen und einen Speicher (26) enthält, der eine detektierte Überspannung mit Uhrzeit des Auftretens und mindestens einem Amplitudenwert speichert.

2. Vorrichtung nach Anspruch 1, **dadurch gekennzeichnet, dass** der Speicher (26) ein kontinuierliches Journal des Spannungsverlaufs speichert.

3. Vorrichtung nach Anspruch 1, **dadurch gekennzeichnet, dass** ein Spannungsdetektor vorgesehen ist, der nur im Falle von Überspannungen die Speicherung des Spannungsverlaufs veranlasst und die Speicherung eine vorbestimmte Zeit nach Beendigung der Überspannung beendet.

4. Vorrichtung nach einem der Ansprüche 1 - 3, **dadurch gekennzeichnet, dass** im Falle einer Überspannung auch deren Herkunft - Lieferseite (LS) oder Verbraucherseite (VS) - ermittelt und gespeichert wird.

5. Vorrichtung nach einem der Ansprüche 1 - 4, **dadurch gekennzeichnet, dass** ein Ablesegerät (30) vorgesehen ist, dass mit einer Schnittstelle (28, 29) des Überwachungsmoduls (10) verbindbar ist zum Übertragen des Inhalts des Speichers (26) an das Ablesegerät.

6. Vorrichtung nach Anspruch 5, **dadurch gekennzeichnet, dass** das Überwachungsmodul (10) eine unverwechselbare Kennung aufweist und diese an das Ablesegerät (30) überträgt.

7. Vorrichtung nach einem der Ansprüche 1 - 6, **dadurch gekennzeichnet, dass** das Ablesegerät (30) mit einem Passwort gesichert ist.

8. Vorrichtung nach einem der Ansprüche 1 - 7, **dadurch gekennzeichnet, dass** mindestens ein Hilfsmodul (35, 36, 37) vorgesehen ist, das mit dem Überwachungsmodul (10) kommuniziert und ein elektrisches Gerät oder einen Störungsmelder überwacht, wobei das Überwachungsmodul die Speicherung der Signale des Hilfsmoduls vornimmt.

9. Vorrichtung nach Anspruch 8, **dadurch gekennzeichnet, dass** ein Störungsmelder ein Windmesser (38) oder ein Hagelsensor ist.

10. Vorrichtung nach Anspruch 8, **dadurch gekennzeichnet, dass** ein Störungsmesser ein Rauchmelder ist.

11. Vorrichtung nach einem der Ansprüche 1 - 10, **dadurch gekennzeichnet, dass** das Überwachungsmodul (10) auch den Stromverbrauch innerhalb der Aufzeichnungszeit speichert.

12. Vorrichtung nach einem der Ansprüche 1 - 11, **dadurch gekennzeichnet, dass** eine Einrichtung zum Verschlüsseln der zu speichernden Daten vorgesehen ist.
